# EUROPÄISCHE PATENTSCHRIFT

(11) **EP 2 761 371 B1**
(45) Veröffentlichungstag und Bekanntmachung des Hinweises auf die Patenterteilung: **12.08.2015**
(21) Anmeldenummer: 11796958.4
(22) Anmeldetag: 06.12.2011
(51) Int. Cl.: G03F 7/00, B29C 59/02, B82Y 10/00, B82Y 40/00

(54) **VERFAHREN ZUR HERSTELLUNG EINES NANOSTRUKTURSTEMPELS**
METHOD FOR PRODUCING A STAMP FOR NANOIMPRINTING
PROCÉDÉ POUR LA FABRICATION D'UNE MATRICE D'ESTAMPAGE DE NANOSTRUCTURES

(43) Veröffentlichungstag der Anmeldung: 06.08.2014
(73) Patentinhaber: Ev Group E. Thallner GmbH, 4782 St. Florian am Inn (AT)
(72) Erfinder: KREINDL, Gerald, A-4782 Schärding (AT); WIMPLINGER, Markus, A-4910 Ried im Innkreis (AT); GLINSNER, Thomas, A-4782 St. Florian (AT)
(74) Vertreter: Schweiger, Johannes
(86) Internationale Anmeldenummer: PCT/EP2011/071912
(87) Internationale Veröffentlichungsnummer: WO 2013/083184

(56) Entgegenhaltungen:
- DE-A1- 3 932 198
- DE-A1- 19 627 638
- US-A- 5 266 257
- US-A- 5 327 825
- JUN TANIGUCHI ET AL: "Large-diameter roll mold fabrication method using a small-diameter quartz roll mold and UV nanoimprint lithography", JOURNAL OF VACUUM SCIENCE & TECHNOLOGY B: MICROELECTRONICS AND NANOMETER STRUCTURES, Bd. 29, Nr. 6, 1. Januar 2011 (2011-01-01) , Seite 06FC08, XP55036307, ISSN: 1071-1023, DOI: 10.1116/1.3657524

## Beschreibung

Die vorliegende Erfindung betrifft ein Verfahren zur Herstellung eines Nanostrukturstempels zur Herstellung einer Prägerolle gemäß Patentanspruch 2 sowie die Verwendung eines Rotationskörpers einer Prägerolle zur Herstellung eines Nanostrukturstempels gemäß Anspruch 1.

In der Entwicklung der Massenfertigungstechnologien von nanostrukturierten Oberflächen und Halbleiterstrukturen für Großflächenanwendungen wie beispielsweise Folien besteht ein Bedarf für funktionierende Rolle-zu-Rolle-Mäschinen, die in der Lage sind, kontinuierliche nanostrukturierte und/oder Halbleiterstrukturen über Rollen auf ein Laufband oder ein langes Werkstück zu prägen. Dabei bestehen erhebliche Probleme, insbesondere bei einer Anwendung für die Imprint-Lithographie, was bisher nicht zufrieden stellend gelöst wurde.

Insbesondere stellt es ein Problem dar, kontinuierliche Muster im Submikro- beziehungsweise Nanometerbereich zu erzeugen. Es ist leicht vorstellbar, dass bei immer kleiner werdenden Prägestrukturen die technischen Probleme bei der Umsetzung einer Endlosaufbringung überdurchschnittlich ansteigen.

Aufgabe der vorliegenden Erfindung ist es daher, ein Verfahren zur Herstellung, eines Nanostrukturstempel anzugeben, mit welchen das Endlosprägen von Nanostrukturen auch bei sehr kleinen Abmessungen der Nanostrukturen, insbesondere im Verhältnis zur Größe oder zum Durchmesser der Prägerolle möglich ist, wobei zuverlässig und reproduzierbare Ergebnisse erzielt werden können. Die Durchmesser gängiger Prägerollen sind dem Fachmann bekannt. Die erfindungsgemäße Ausführungsform ist allerdings für jeden Durchmesser geeignet.

Diese Aufgabe wird mit den Merkmalen der Patentansprüche 1 und 2 . Vorteilhafte Weiterbildungen der Erfindung sind in dem Unteranspruch angegeben. Den in Anspruch 3 angegebenen Wertebereichen sollen auch innerhalb der genannten Grenzen liegende Werte als Grenzwerte offenbart sein.

Der Erfindung liegt der Gedanke zugrunde, eine auf die Prägerolle aufzubringende Prägestruktur im step-and-repeat-Verfahren derart aufzubringen, dass eine nahtlose Prägung am gesamten Umfang vorgesehen ist. Hierzu wird ein neuartiger Nanostrukturstempel offenbart, der für einen step-and-repeat-Prozess geeignet ist, um eine sich wiederholende Struktur am Umfang der Prägerolle aufzubringen. Erfindungsgemäß ist es auch denkbar, die Struktur entlang einer Rotationsachse des Rotationskörpers der Prägerolle im step-and-repeat-Verfahren aufzubringen. Erfindungsgemäß ist es von besonderer Bedeutung, mit der Prägung in mehreren Schritten eine nahtlose Mikrobeziehungsweise Nanostruktur zu erzeugen, damit die Prägerolle beim späteren Abrollprozess auf das Werkstück (Herstellung eines Prägesubstrats, auch Prägeprodukts) quasi endlos beziehungsweise kontinuierlich, also durch eine Vielzahl von ganzen Drehungen, übertragen werden kann. Die mit step-and-repeat-Verfahren erzielbare hochsymmetrische und translatorische Wiederholung der Muster erlaubt es, Materialien mit einzigartigen Oberflächeneigenschaften, insbesondere mit sich periodisch wiederholenden Strukturen, zu generieren. Besonders vorteilhaft ist die Verwendung im Bereich der Optik, beispielsweise beim Imprinten von Glasplatten. Die Symmetrie ist in der Optik von sehr großer Bedeutung, insbesondere wenn durch hochsymmetrische Strukturen die gewünschten optischen Effekte auf das genaueste erzielt werden können. Nahtlos bedeutet dabei, dass innerhalb der Toleranzen des step-and-repeat-Prozesses am gesamten Umfang homogene Strukturen geprägt werden, insbesondere auch an dem Übergang des letzten Prägeschrittes zum ersten Prägeschritt einer umfänglichen Prägung der Prägerolle.

Es ist daher ein Nanostrukturstempel mit einer beispielsweise konkav gekrümmten nanostrukturierten Stempelfläche zur nahtlosen Prägung zumindest eines Umfangsrings einer Mantelfläche einer Prägerolle im step-and-repeat-Verfahren vorgesehen. Die Stempelfläche des Nanostrukturstempels ist somit an die Mantelfläche der Prägerolle angepasst, so dass mit einem einzigen Nanostrukturstempel die gesamte Mantelfläche einer Prägerolle geprägt werden kann. Der gleichzeitige Einsatz mehrerer Nanostrukturstempel bei der Prägung einer Prägerolle ist ebenfalls denkbar.

Soweit der Nanostrukturstempel einen Stempelträger aufweist, mit dem eine die Stempelfläche umfassende Stempelform, insbesondere permanent, verbunden ist, wird die Handhabung des Nanostrukturstempels in einer entsprechenden Vorrichtung zur Prägung der Prägerolle vereinfacht.

Besonders vorteilhaft ist es dabei, wenn die Stempelform direkt von der zu prägenden Prägerolle erzeugt wird. Auf diese Weise entspricht die Krümmung des Nanostrukturstempels beziehungsweise der Stempelfläche des Nanostrukturstempels exakt der zu prägenden Prägerolle.

Gemäß einer vorteilhaften Ausführungsform der Erfindung ist der Stempelträger durchlässig für elektromagnetische Wellen, insbesondere UV-Licht, um ein Aushärten der Stempelform und/oder der zu prägenden Prägeschicht der Prägerolle vorsehen zu können.

Soweit sich eine Strahlungsquelle für elektromagnetische Wellen, insbesondere eine UV-Quelle, im Inneren der Prägerolle, insbesondere in Form eines Hohlzylinders, befindet, ist vorzugsweise ein Abschirmmittel für die elektromagnetischen Wellen in nicht zu beaufschlagenden Bereichen der Prägerolle, insbesondere an deren Innenumfang, vorgesehen. Dies ist vorzugsweise ein UV undurchlässiger Schutzmantel, der all jene Stellen, die nicht belichtet werden sollen schützt, und nur an jenen Bereichen unterbrochen ist, durch die das UV Licht treten soll um die UV aushärtbare Prägeschicht auszuhärten.

Mit Vorzug ist ein Bogenmaß der Stempelfläche des erfindungsgemäßen Nanostrukturstempels in einer Abrollrichtung an der Prägerolle in Bezug auf einen korrespondierenden Kreisumfang der zu prägenden Prägeschicht ein ganzzahliger Teil, so dass bei einer vollständigen Prägung des Kreisumfangs der Prägeschicht in Abrollrichtung der Prägerolle eine nahtlose Prägung erfolgt. Soweit ein Überlappungsabschnitt bei den einzelnen Prägeschritten vorgesehen ist, ist das Bogenmaß um den Überlappungsabschnitt zu erweitern.

Zusätzlich ist vorgesehen, den Stempel durch Verformungsmittel, insbesondere durch externe Einflussnahme, dynamisch im Mikro- und/oder Nanometerbereich, insbesondere in Abrollrichtung, verformen, insbesondere dehnen und/oder stauchen, zu können.

In einer Ausführungsform der Verformungsmittel wird das durch die thermische Ausdehnung des Stempels durch Erhitzen und/oder Kühlen erreicht. In einer anderen Ausführungsform werden Piezomaterialien verwendet. Für einen Fachmann auf dem Gebiet ist klar, dass die Dehnung des Stempels auf beliebige Art und weise erreicht werden kann, solange gewährleistet ist, dass die Prägestrukturen beim Schließen der Oberfläche nahtlos ineinander übergehen. Hierzu können Messmittel zum Ausmessen der Verhältnisse der Stempelfläche gegenüber dem Kreisumfang der Prägerolle vorgesehen sein, insbesondere zur Erfassung während der Bearbeitung (Prägung). Alternativ kann der Grad der Verformung durch Kalibrierung, insbesondere durch einen Prägung des Umfangs, festgelegt werden. Auch ist es erfindungsgemäß denkbar, den Umfang der Prägerolle mit und/oder ohne Prägeschicht einerseits und die Abmessung der Stempelfläche andererseits auszumessen und dann die Verformung zu ermitteln, insbesondere durch Berechnung. Als Messverfahren eignen sich erfindungsgemäß insbesondere Rasterkraftmikroskope und/oder optische Mikroskope und/oder Rasterelektronenmikroskope.

Es ist auch die - insbesondere mit dem Nanostrukturstempel hergestellte - Prägerolle zum Endlosprägen von Nanostrukturen mit einer auf einen Rotationskörper aufgebrachten Prägeschicht mit einer Mantelfläche mit mindestens einem zumindest in Umfangsrichtung nahtlos ausgebildeten, im step-and-repeat-Verfahren geprägten Umfangsring vorgesehen. Mit der Prägerolle können sich periodisch wiederholende Strukturen auf ein Werkstück aufgebracht werden.

Indem die Mantelfläche durch den Nanostrukturstempel geprägt wird, ist die Prägerolle auf vorteilhafte Weise herstellbar.

Besonders vorteilhaft ist es, wenn der Rotationskörper als Zylinder, insbesondere Kreiszylinder ausgebildet ist. Somit lässt sich die Prägerolle sowohl bei der Herstellung der Prägerolle als auch bei der funktionsgemäßen Verwendung der Prägerolle beim Endlosprägen von Nanostrukturen (Imprinten) in vorteilhafter Weise verwenden.

Es ist außerdem eine Vorrichtung zur Herstellung einer erfindungsgemäßen Prägerolle zum Endlosprägen von Nanostrukturen vorgesehen. Diese weist eine Prägerollenaufnahme zur Aufnahme und steuerbaren Rotation eines Rotationskörpers der Prägerolle um eine Prägerollenachse in einem Arbeitsraum auf. Die Steuerung erfolgt insbesondere über eine zentrale Steuereinrichtung. Weiterhin weist die Vorrichtung eine Stempelaufnahme zur Aufnahme und steuerbaren Bewegung eines Nanostrukturstempels relativ zu einer Mantelfläche der Prägerolle auf. Die Steuerung erfolgt ebenfalls durch die zentrale Steuereinrichtung, wobei durch Steuerung der Prägerollenaufnahme und der Stempelaufnahme mindestens ein zumindest in Umfangsrichtung der Mantelfläche nahtlos ausgebildeter, im step-and-repeat-Verfahren geprägter Umfangsring herstellbar ist. In einer vorteilhaften Ausführungsform der Vorrichtung ist der Arbeitsraum durch eine Vakuumkammer gebildet und mit Vakuum beaufschlagbar, so dass während der Herstellung der Prägerolle eine für die Herstellung geeignete Atmosphäre einstellbar ist.

Gemäß einer weiteren Ausführungsform ist mit Vorteil vorgesehen, dass Mittel zur Aufbringung einer die Mantelfläche bildenden Prägeschicht auf einen Rotationskörper der Prägerolle vorgesehen sind. Diese Ausführungsform sorgt für eine weitere Integration.

In einer weiteren, vorteilhaften Ausführungsform ist vorgesehen, dass die Vorrichtung Aushärtemittel zum, insbesondere abschnittsweisen, vorzugsweise mit dem step-and-repeat-Verfahren entsprechenden, insbesondere einer Stempelfläche des Nanostrukturstempels korrespondierenden, Abschnitten, Aushärten des geprägten Umfangrings aufweist.

Weiterhin betrifft eine eigenständige Erfindung ein Verfahren zur Herstellung eines Nanostrukturstempels zur Herstellung einer Prägerolle zum Endlosprägen von Nanostrukturen mit folgenden Schritten, insbesondere folgendem Ablauf:
- Fixierung eines gekrümmten oder krümmbaren Stempelnegativs des Nanostrukturstempels auf einem Umfangsabschnitt einer Mantelfläche eines Rotationskörpers,
- Aufbringung eines formbaren Stempelformmaterials auf das gekrümmte Stempelnegativ,
- Anformung des Stempelformmaterials an einem Stempelträger zur Ausbildung einer konkav gekrümmten, nanostrukturierten Stempelfläche,
- Aushärtung des Stempelformmaterials.

Dabei ist es gemäß einer vorteilhaften Ausführungsform der Erfindung vorgesehen, dass sich der Umfangsabschnitt über weniger als die Hälfte, insbesondere weniger als ⅓, vorzugsweise weniger als ¼ des Umfangs der Mantelfläche erstreckt. Durch diese Maßnahmen wird die Prägekraft gleichmäßiger aufgebracht.

Soweit als Rotationskörper ein Rotationskörper der Prägerolle verwendet wird, entspricht die Krümmung der Stempelfläche exakt der Form der Prägerolle beim Prägen, insbesondere wenn die Dicke des Stempelnegativs in etwa der Dicke der Prägeschicht auf der Prägerolle entspricht.

Gemäß einem weiteren, eigenständigen Aspekt wird ein Verfahren zur Herstellung einer Prägerolle zum Endlosprägen von Nanostrukturen mit folgenden Schritten, insbesondere folgendem Ablauf beschrieben:
- Aufnahme eines Rotationskörpers mit einer eine Mantelfläche aufweisenden Prägeschicht auf eine in einem Arbeitsraum angeordnete Prägerollenaufnahme,
- Prägung eines in Umfangsrichtung der Mantelfläche nahtlos ausgebildeten Umfangsrings mittels eines auf einer Stempelaufnahme aufgenommenen Nanostrukturstempels im step-and-repeat-Verfahren.

Indem durch Rotation des Rotationskörpers in mehreren, insbesondere sequentiell verlaufenden, Stempelschritten geprägt wird, stimmt die Anordnung des Umfangsrings exakt mit der Rotationsachse des Rotationskörpers der Prägerolle überein.

Gemäß einer weiteren, vorteilhaften Ausführungsform ist vorgesehen, dass die Stempelschritte zur Ausrichtung an der jeweils vorher geprägten Struktur teilweise überlappend ausgeführt werden. Auf diese Weise ist eine Ausrichtung des Nanostrukturstempels an vorher geprägten und ausgehärteten Strukturen erfindungsgemäß denkbar, so dass eine hochgenaue Ausrichtung an Hand der durch die verschiedenen Stempelschritte geprägten Strukturen erfolgt.

Dadurch, dass mehrere Stempelschritte parallel zur Rotationsachse in jeder Rotationslage vorgesehen sind, ist die Prägerolle nach einer einzigen, vollständigen Rotation um die Rotationsachse (also etwa 360 Grad, gegebenenfalls mit einer geringen Überlappung) fertig geprägt.

Vorrichtungsgemäß offenbarte Merkmale sollen auch als Verfahrensmerkmale offenbart gelten und umgekehrt.

Weitere Vorteile, Merkmale und Einzetheiten der Erfindung ergeben sich aus der nachfolgenden Beschreibung bevorzugter Ausführungsbeispiele sowie anhand der Zeichnungen; diese zeigen jeweils in schematischer Ansicht:
- Figur 1a: eine erste Ausführungsform der Vorrichtung zur Herstellung einer Prägerolle zum Endlosprägen von Nanostrukturen,
- Figur 1b: eine zweite Ausführungsform der Vorrichtung zur Herstellung einer Prägerolle zum Endlosprägen von Nanostrukturen,
- Figuren 2a bis 2f: eine Ausführungsform eines erfindungsgemäßen Verfahrens zur Herstellung eines Nanostrukturstempels zur Herstellung einer Prägerolle zum Endlosprägen von Nanostrukturen,
- Figuren 3a bis 3g: eine Ausführungsform eines erfindungsgemäßen Verfahrens zur Herstellung einer Prägerolle zum Endlosprägen von Nanostrukturen,
- Figur 4a: eine Aufsicht auf eine teilweise geprägte Prägerolle nach einem ersten step-and-repeat-Verfahrensablauf und
- Figur 4b: eine Aufsicht auf eine Prägerolle mit teilweise geprägten Strukturen nach einer zweiten Ausführung des step-and-repeat-Verfahrens.
- Figur 5: ein Verfahrensablauf des Endlosprägens mittels der Prägerolle zur Herstellung eines "endlos" beziehungsweise kontinuierlich geprägten Prägesubstrats,

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

In den Figuren sind die erfindungsgemäßen Merkmale nicht maßstabsgetreu dargestellt, um die Funktion der einzelnen Merkmale überhaupt darstellen zu können. Auch die Verhältnisse der einzelnen Bauteile sind teilweise unverhältnismäßig, was insbesondere auf stark vergrößert dargestellte Nanostrukturen 14 zurückzuführen ist. Die Nanostrukturen 14, die mit der vorliegenden Erfindung geprägt werden beziehungsweise zum Prägen von korrespondierenden Nanostrukturen auf Werkstücke verwendet werden, liegen im Nano- und/oder Mikrometerbereich, während die Größenordnung der Maschinenbauteile im Zentimeterbereich liegt.

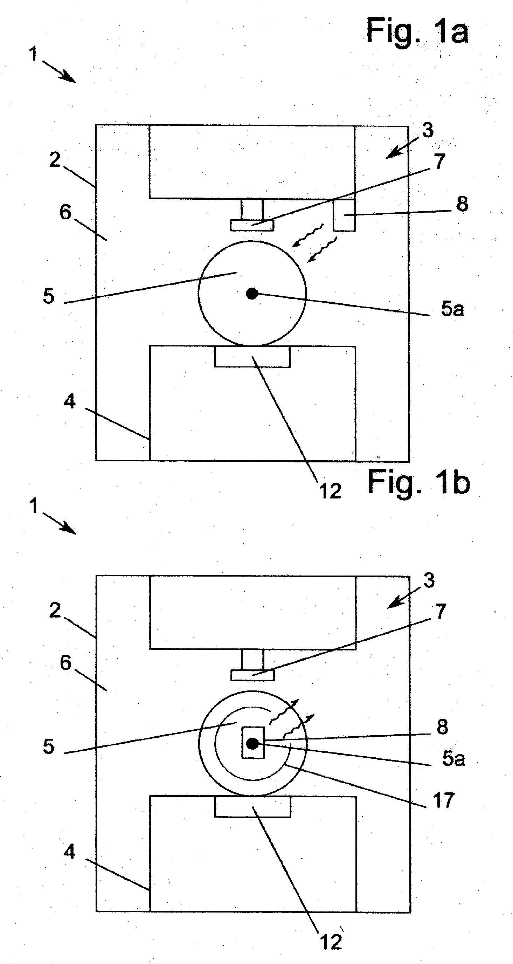

In Figur 1 ist eine Vakuumkammer 2 schematisch dargestellt, die einen Arbeitsraum 6 umgibt, der mit Vakuum beaufschlagbar ist. Die Vakuumkammer 2 kann über eine nicht dargestellte, abgedichtete Tür oder Schleuse beladen werden.

In dem Arbeitsraum 6 ist an einem Boden 2b der Vakuumkammer 2 eine Prägerollenaufnahme 4 zur Aufnahme und steuerbaren Rotation eines Rotationskörpers 5 angeordnet. Der Rotationskörper 5 ist Bestandteil einer Prägerolle 16 zum Endlosprägen der Nanostrukturen 14, wobei die Prägerolle 16 mit der in Figur 1 gezeigten Vorrichtung hergestellt wird. Die Rotation des Rotationskörpers 5 erfolgt um eine Prägerollenachse 5a, die konzentrisch zu dem Rotationskörper 5 in Form eines Kreiszylinders verläuft. Entsprechende Antriebsmittel zum exakt steuerbaren Antrieb des Rotationskörpers 5 zumindest in einer Rotationsrichtung werden als bekannt vorausgesetzt.

Oberhalb des Rotationskörpers 5 ist mittels einer Stempelaufnahme 3 ein Nanostrukturstempel 1 anordenbar, wobei die Stempelaufnahme 3 zur Aufnahme und steuerbaren Bewegung des Nanostrukturstempels 1 relativ zu einer Mantelfläche 5o des Rotationskörpers 5 beziehungsweise der Prägerolle 16 zumindest in einer X-, Y- und einer Z-Richtung bewegbar ist. Die Relativbewegung in X- und/oder Y- und/oder Z-Richtung kann durch Bewegung des Nanostrukturstempels 1 mittels der Stempelaufnahme 3 und/oder durch Bewegung des Rotationskörpers 5 durch die Prägerollenaufnahme 4 erfolgen. Somit ist die gezeigte Vorrichtung geeignet, einen step-and-repeat-Prozess durchzuführen.

Mit anderen Worten: Der Nanostrukturstempel 1 weist mindestens drei translatorische Freiheitsgrade (X-, Y- und Z-Richtung), insbesondere zusätzlich einen rotatorischen Freiheitsgrad relativ zu dem Rotationskörper 5, auf. Der Rotationskörper 5 weist einen Freiheitsgrad in Rotationsrichtung um die Prägerollenachse 5a auf, insbesondere zusätzlich zwei translatorische Freiheitsgrade (in X- und Y-Richtung). Der rotatorische Freiheitsgrad des Rotationskörpers 5 ist vorgesehen, um den Rotationskörper 5 nach einem Prägeschritt beziehungsweise der Prägung mehrerer Prägeschritte um die Prägerollenachse 5a weiterzudrehen.

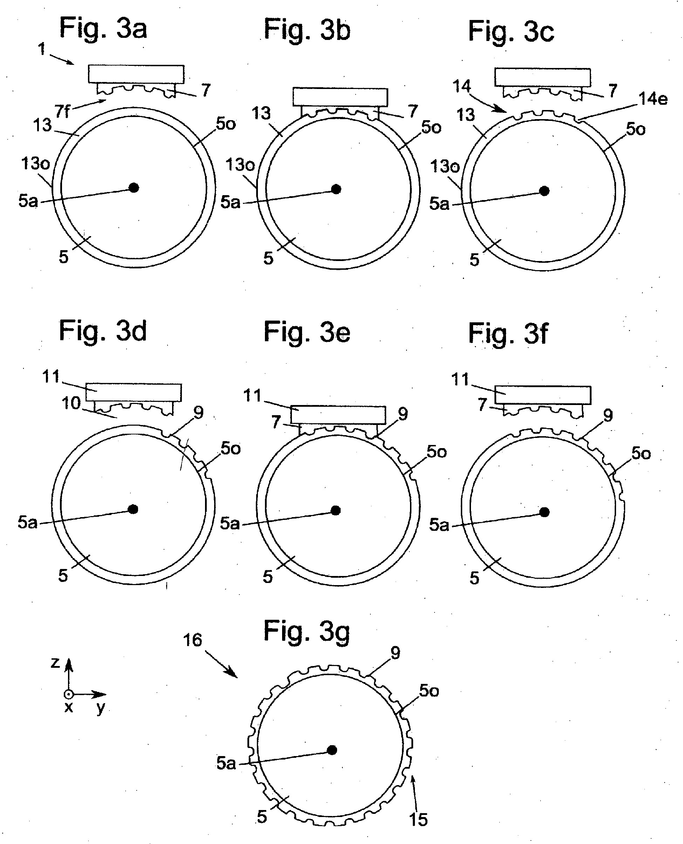

Gemäß Figur 1 sind darüber hinaus Aushärtemittel in Form einer UV-Quelle 8 und/oder eines Heizsystems 12 zum Aushärten von mit dem Nanostrukturstempel 1 an der Mantelfläche 5o (nähere Beschreibung siehe unten zu Figuren 3a bis 3g) geprägten Nanostrukturen 14 vorgesehen. Die UV-Quelle 8 und/oder das Heizsystem 12 haben relativ zum Nanostrukturstempel 1 so positioniert zu sein, dass die Aushärtung der gerade neu hergestellten Nanostrukturen 14 nach einer gewissen Zeitspanne, mit Vorzug möglichst schnell, mit größtem Vorzug sofort, erfolgt. Die Positionierung des Heizsystems 12 gem. Fig. 1a gegenüber des Nanostrukturstempels 1 ist daher nicht die optimale, aber anschaulichste Ausführungsform. In einer speziellen Ausführungsform kann sich die UV Quelle auch innerhalb eines (Hohl)zylinders (Rotationskörper 5) gem. Fig 1b befinden. Die UV-Quelle 8 kann dabei von einem, insbesondere gegenüber beziehungsweise relativ zu dem Rotationskörper rotierbaren, Schutzmantel 17 (Abschirmmittel) umgeben sein, um sicherzustellen, dass das UV Licht nur in einem auszuhärtenden Bereich auf die Prägeschicht 13 trifft.

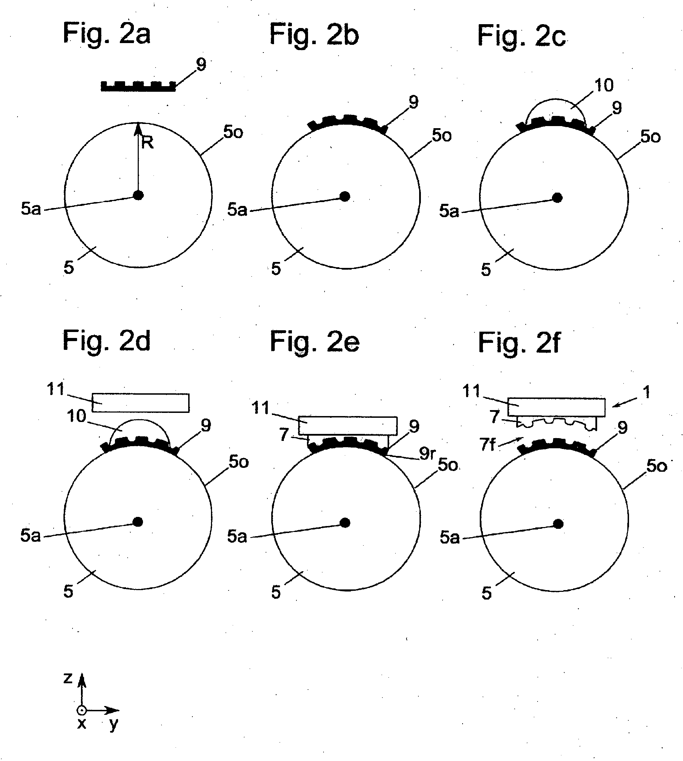

Zunächst wird die Herstellung des Nanostrukturstempels 1 gemäß Figuren 2a bis 2f erläutert, die insbesondere für die Produktion mehrerer Prägerollen 16 nur einmal durchgeführt zu werden braucht, da mit Vorzug mit einem Nanostrukturstempel 1 mehrere Prägerollen 16 hergestellt werden können.

Zunächst wird ein Stempelnegativ 9 (Negativ des Nanostrukturstempels 1) auf einem ebenen, planaren Substrat ausgebildet (siehe Figur 2a). Das planare Substrat besteht vorzugsweise aus einem Polymer oder einer dünnen strukturierten Metallfolie oder einem Material, das biegsam an eine gekrümmte Oberfläche (hier die Mantelfläche 5o des Rotationskörpers 5, der für die Herstellung der Prägerolle 16 dient) anpassbar ist. Somit entspricht die Form des Stempelnegativs 9 nach Aufbringung auf die Mantelfläche 5o gemäß Figur 2b exakt der Form der zu prägenden Nanostrukturen 14, insbesondere wenn die Dicke des Stempelnegativs 9 der Dicke einer auf die Mantelfläche 5o aufzubringenden Prägeschicht 13 (siehe Figur 3a) entspricht. Die Prägeschicht 13 ist dünner als 1 mm, mit Vorzug dünner als 0,1 mm, mit größerem Vorzug dünner als 1 µm, mit noch größerem Vorzug dünner als 0,1 µm, mit größtem Vorzug dünner als 100 nm, mit allergrößtem Vorzug dünner als 10 nm.

Anschließend wird ein Stempelformmaterial 10 auf das Stempelnegativ 9 durch nicht dargestellte Mittel zur Aufbringung des Stempelformmaterials 10 aufgebracht (siehe Figur 2c). Die Aufbringung kann semi- oder vollautomatisch erfolgen, aber auch eine manuelle Aufbringung ist erfindungsgemäß denkbar.

Anschließend wird ein Stempelträger 11 gegenüber dem Stempelnegativ 9 positioniert, so dass das Stempelformmaterial 10 zwischen dem Stempelnegativ 9 und dem Stempelträger 11 angeordnet ist (siehe Figur 2d). Zur Positionierung/Ausrichtung/Halterung des Stempelträgers 11 sind entsprechende Mittel, insbesondere ein Roboterarm, vorgesehen.

In dem in Figur 2e gezeigten Verfahrensschritt wird der Stempelträger 11 in Richtung des Rotationskörpers 5 beziehungsweise der Prägerollenachse 5a beziehungsweise dem Stempelnegativ 9 bewegt, so dass sich das Stempelformmaterial 10 zwischen dem Stempelnegativ 9 und dem Stempelträger 11 verteilt. Hierdurch werden die Strukturen (Vertiefungen und Erhebungen) des Stempelnegativs 9 mit dem Stempelformmaterial 10 bis an oder über einen Rand 9r des Stempelnegativs 9 hinaus ausgefüllt.

Durch nicht dargestellte Aushärtemittel (analog Figur 1) werden das Stempelformmaterial 10 ausgehärtet und an einer Stempelfläche 7f einer hierdurch gebildeten Stempelform 7 ein Stempelpositiv gebildet. Gleichzeitig verbindet sich die Stempelform 7 mit dem Stempelträger 11, insbesondere permanent. Als Aushärtemittel dienen insbesondere UV-Strahler, Infrarot-Strahler oder Heizer. Es ist außerdem denkbar, den Rotationskörper 5 selbst zu heizen, insbesondere durch Anordnung eines elektromagnetischen Strahlers im Inneren des Rotationskörpers 5.

Nach Aushärtung wird der fertige Nanostrukturstempel 1 von dem Rotationskörper 5 beziehungsweise dem Stempelnegativ 9 abgehoben.

Alternativ zu dem vorbeschriebenen Nanostrukturstempel ist auch die Herstellung eines Hartstempels denkbar, der mit erheblichem Mehraufwand auf bekannte Art und Weise hergestellt wird, jedoch in den anderen, erfindungsgemäßen Aspekten bei der Herstellung der Rolle zum Einsatz kommen kann. Solche Hartstempel sind allerdings aufwendig und kostspielig, insbesondere mit Lithographie- und/oder Elektronenstrahl- und/oder Fräsverfahren herzustellen, was bei der gekrümmten Stempeltopographie und den sehr kleinen Strukturen verglichen mit der erfindungsgemäßen Lösung äußerst schwer zu realisieren ist.

In Figur 3 kommt der Nanostrukturstempel 1 in der in Figur 1 gezeigten Vorrichtung zum Einsatz. Zunächst wird der Rotationskörper 5 an seiner, insbesondere gesamten, Mantelfläche 5o mit der Prägeschicht 13 beschichtet, so dass diese eine (neue) Mantelfläche 13o ausbildet. Die Beschichtung der Prägeschicht 13 erfolgt vorzugsweise durch Rotation des Rotationskörpers 5 in einem nur einen Umfangsabschnitt des Rotationskörpers aufnehmenden Tauchbad oder durch Sprühverfahren, Tropfendispension, PVD-Verfahren oder CVD-Verfahren. Alternativ ist das Eintauchen des gesamten Rotationskörpers 5 in ein Tauchbad denkbar. Als Beschichtungsmaterial für die Prägeschicht 13 wird vorzugsweise ein flüssiges Polymer verwendet. Nach Beaufschlagung der Mantelfläche 5o mit dem Material der Prägeschicht 13 wird die Prägeschicht 13 in der gewünschten Dicke, insbesondere dünner als 1 mm, mit Vorzug dünner als 0,1 mm, mit größerem Vorzug dünner als 1 µm, mit noch größerem Vorzug dünner als 0,1 µm, mit größtem Vorzug dünner als 100 nm, mit allergrößtem Vorzug dünner als 10 nm, hergestellt.

Die Prägestrukturen selbst haben eine mittlere laterale Auflösung von weniger als 1 mm, mit Vorzug weniger als 0,1 mm, mit größerem Vorzug weniger als 1 µm, mit noch größerem Vorzug weniger als 0,1 µm, mit größtem Vorzug weniger als 100 nm, mit allergrößtem Vorzug weniger als 10 nm.

Der Durchmesser der Prägerollen (16) ist beliebig wählbar. Beispielhaft aber nicht ausschließend ist er größer als 1 mm, mit Vorzug größer als 1 cm, mit größerem Vorzug größer als 10 cm, mit größtem Vorzug größer als 1 m, mit allergrößtem Vorzug größer als 10m. Erste Prototypen der erfindungsgemäßen Ausführüngsform werden mit Durchmessern der Prägerolle (16) zwischen 10 cm und 50 cm realisiert. Je größer der Durchmesser der Prägerolle (16), desto sanfter die Trennung der Mikro- und/oder Nanostrukturen (14) aus den Nanostrukturen (19).

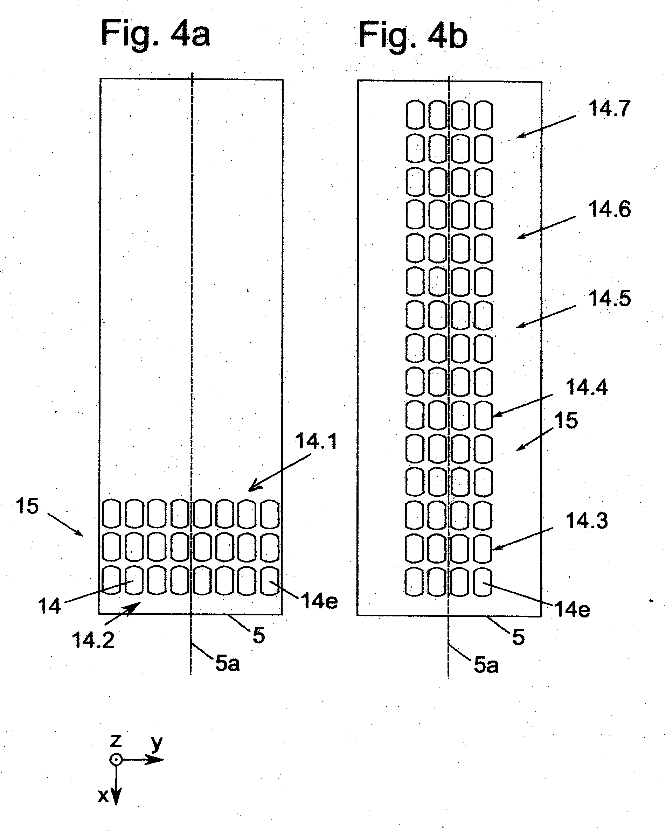

Anschließend wird der Rollenträger 5 mit der aufgebrachten und ausgehärteten Prägeschicht 13 (wie in Figur 3a beziehungsweise Figur 1 gezeigt) positioniert und ausgerichtet, und zwar nicht nur in Y-Richtung und der Rotationslage beziehungsweise Winkellage des Nanostrukturstempels gegenüber dem Rotationskörper 5, sondern auch in X-Richtung entlang der Mantelfläche 13o parallel zur Prägerollenachse 5a (siehe hierzu insbesondere Figuren 4a und 4b). Außerdem ist es essentiell, den Nanostrukturstempel 1 in der Rotationslage exakt auszurichten.

Nach Ausrichtung wird der Nanostrukturstempel 1 in Z-Richtung (also auf die Prägerollenachse 5a zu) bewegt, bis ein erster Prägeabschnitt 14.1 (Fig. 4a) beziehungsweise 14.3 (Fig. 4b) der Nanostrukturen 14 aus dem Stempelpositiv der Stempelfläche 7f geprägt ist. Erfindungsgemäß werden zumindest überwiegend, vorzugsweise vollständig, benachbarte Strukturabschnitte 14.n sequenziell geprägt, da auf diese Weise eine Ausrichtung an zuvor geprägten Strukturen, insbesondere einer Überlappungsstruktur 14e (Überlappungsabschnitt) am Rand eines vorhergeprägten Strukturabschnitts 14.[n-1]) möglich ist. Beim sequenziellen Prägen bestehen die in der Figur 4a und der Figur 4b gezeigten Alternativen.

Bei der in Figur 4a gezeigten Ausführungsform wird zunächst als erster Stempelschritt ein zur Stempelfläche 7f korrespondierender Nanostrukturabschnitt 14.1 geprägt und anschließend durch Rotation des Rotationskörpers 5 ein zweiter Strukturabschnitt 14.2 in einem Stempelschritt geprägt.

Bei der in Figur 4b gezeigten Ausführungsform wird nach der Prägung eines ersten Nanostrukturabschnitts 14.3 eine parallel, zur Prägerollenachse 5a verlaufende Reihe aus mehreren Strukturabschnitten 14.3, 14.4, 14.5, 14.6 und 14.7 sequenziell geprägt, währenddessen keine Rotation des Rotationskörpers 5 stattfindet. Somit braucht während der hier gezeigten fünf Prägeschritte nur der Nanostrukturstempel 1 in X-Richtung bewegt und, insbesondere an einer Struktur des jeweils vorher geprägten Nanostrukturabschnitts 14.[n-1] ausgerichtet werden. Nach Prägung der Nanostrukturabschnitte 14.3 bis 14.7 erfolgt eine Rotation des Rotationskörpers 5, so dass die nächste Reihe geprägt werden kann und so weiter.

Jeder Prägeschritt besteht aus den in Figuren 3c bis 3e gezeigten Schritten, nämlich Abheben des Nanostrukturstempels 1 (Figur 3c), Rotation des Rotationskörpers 5 und/oder Bewegung des Nanostrukturstempels 1 in X-Richtung (siehe Figur 3d) und Prägen des Strukturabschnitts 14.n, insbesondere durch Überlappung mindestens einer am Rand des vorherigen Nanostrukturabschnitts vorgesehenen Überlappungsstruktur 14e (Figur 3e).

Die beschriebenen Vorgänge werden solange wiederholt, bis die gesamte Mantelfläche 13o der Prägeschicht 13 mit Nanostrukturen 14 versehen ist (siehe Figur 3g).

Bei der in Figur 4a gezeigten Ausführungsform wird zunächst ein der Breite der Stempelfläche 7f in X-Richtung entsprechender Umfangsring 15 geprägt, während in der in Figur 4b gezeigten Ausführungsform ein sich praktisch über die gesamte Breite der Mantelfläche 5o erstreckender Umfangsring 15' geprägt wird.

Bei der Ausführungsform gemäß Figur 4a müssen zur Abdeckung der gesamten Mantelfläche 5o demnach mehrere nebeneinander angeordnete Umfangsringe 15 geprägt werden, so dass der Rotationskörper 5 mehrfach um seine eigene Achse vollständig gedreht werden muss. Bei der in Figur 4b gezeigten Ausführungsform ist nur eine einzige Umdrehung um etwa 360 Grad (bei Überlappung etwas mehr) notwendig. Wichtig ist allerdings, dass bei der Überlappung erfindungsgemäß die bereits geprägten Strukturen nicht durch den überlappenden Teil des Stempels zerstört werden, sondern dieser in die bereits vorhandenen Strukturen eingreift, ohne sie zu zerstören.

Jedenfalls ist nach jedem Stempelschritt ein Abheben des Nanostrukturstempels 1 notwendig. Weiterhin ist es erfindungsgemäß bevorzugt, vor oder nach dem Abheben also vor oder nach jedem Stempelschritt eine Aushärtung des geprägten Nanostrukturabschnitts 14.n vorzunehmen. Auch eine Mehrfach-Aushärtung ist denkbar, wobei nach jedem einzelnen Prägeschritt des Nanostrukturstempels 1 eine "Voraushärtung" erfindungsgemäß denkbar ist. Denkbar ist es erfindungsgemäß auch, das Abscheiden des Stempelmaterials (Prägeschicht 13) nur zwischen dem Nanostrukturstempel 1 und der Prägerolle 5 durchzuführen, den Stempel- (Prägen) und Aushärtevorgang durchzuführen, die Prägerolle 5 weiterzudrehen und erst danach den nächsten Teil der Oberfläche 5o zu beschichten. Dadurch wird verhindert, dass allfällig auf der Unter- und Seitenfläche der Prägerolle 5 aufgebrachtes Material, durch die Schwerkraft verformt wird und die Dicke der Prägeschicht 13 inhomogen wird.

Andernfalls ist es erfindungswesentlich, dass die Viskosität der Prägeschicht 13 nach Aufbringung der Prägeschicht 13 gering genug für die Prägung ist, jedoch groß genug, um nicht zu verlaufen.

Erfindungsgemäß ist es bevorzugt, wenn beim Abschließen des Umfangrings 15, also beim Prägen des jeweils für jeden Umfangsring 15 letzten Nanostrukturabschnitts 14.n, ein nahtloser, insbesondere im Abstand mit den übrigen Nanostrukturabschnitten 14.n übereinstimmender Nanostrukturabschnitt 14.n geprägt wird.

Da mit dem erfindungsgemäßen Verfahren ein Nanostrukturstempel 1 auf einfache Art und Weise herstellbar ist, kann ein perfekter Übergang durch Herstellen eines exakt angepassten Nanostrukturstempels 1 erreicht werden.

Um den Nanostrukturstempel 1 an den konkreten Rotationskörper 5 anzupassen, ist eine Probeprägung gemäß eines einzigen Umfangsrings 15 gemäß Figur 4a denkbar. Soweit die Prägung perfekt erfolgt, kann der Nanostrukturstempel 1 für die Herstellung mehrerer Prägerollen 16 verwendet werden. Ansonsten lässt sich die Differenz zum (korrekten) Abstand ermitteln und daraus ein geändertes Stempelnegativ 9 zur Herstellung eines neuen Nanostrukturstempels 1 berechnen.

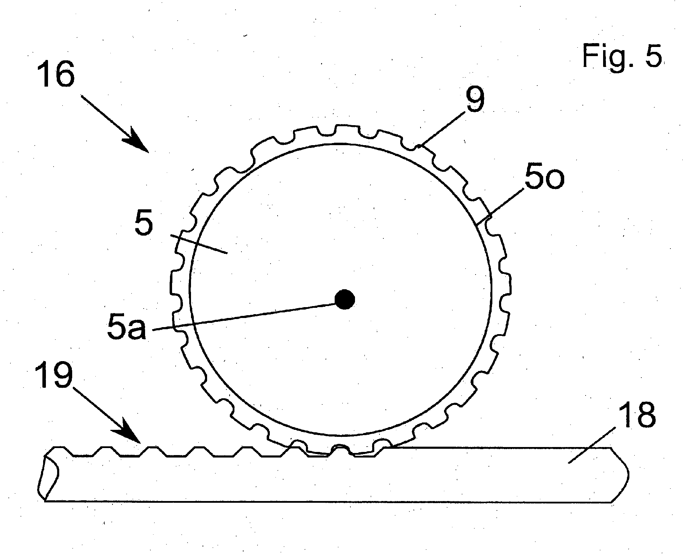

In Figur 5 ist die kontinuierliche Prägung eines quasi endlos mit Nanostrukturen 19 versehenen Prägesubstrats 18 mittels der Prägerolle 5 dargestellt, die im Unterschied zum Stand der Technik zu homogenen und nahtlosen Nanostrukturen 19 auf dem so hergestellten Prägesubstrats 18 führt.

### Bezugszeichenliste

- 1: Nanostruktürstempel
- 2: Vakuumkammer
- 2b: Boden
- 3: Stempelaufnahme
- 4: Prägerollenaufnahme
- 5: Rotationskörper
- 5o: Mantelfläche
- 5a: Prägerollenachse
- 6: Arbeitsraum
- 7: Stempelform
- 7f: Stempelfläche
- 8: Strahler
- 9: Stempelnegativ
- 9r: Rand
- 10: Stempelformmaterial
- 11: Stempelträger
- 12: Heizmittel
- 13: Prägeschicht
- 13o: Mantelfläche
- 14: Nanostrukturen
- 14.1 bis 14.n: Nanostrukturabschnitt
- 14e: Überlappungsstruktur
- 15: Umfangsring
- 16: Prägerolle
- 17: Schutzmantel
- 18: Prägesubstrat
- 19: Nanostrukturen

## Patentansprüche

1. Verwendung eines Rotationskörpers (5) einer Prägerolle (16) zur Herstellung eines Nanostrukturstempels (1) mit einer konkav gekrümmten, nanostrukturierten Stempelfläche (7f) zur nahtlosen Prägung im step-and-repeat-Verfahren zumindest eines Umfangsrings (15, 15') einer Mantelfläche (13o), wobei der Nanostrukturstempel (1) einen Stempelträger (11) aufweist, mit dem eine die Stempelfläche (7f) umfassende Stempelform (7) verbunden ist.

2. Verfahren zur Herstellung eines Nanostrukturstempels (1) zur Herstellung einer Prägerolle (16) zum Endlosprägen von Nanostrukturen mit folgenden Schritten, insbesondere folgendem Ablauf:
- Fixieren eines gekrümmten oder krümmbaren Stempelnegativs (9) des Nanostrukturstempels (1) auf einem Umfangsabschnitt einer Mantelfläche (5o) eines Rotationskörpers (5),
- Aufbringung eines formbaren Stempelformmaterials (10) auf das gekrümmte Stempelnegativ (9),
- Anformung des Stempelformmaterials (10) an einen Stempelträger (11) zur Ausbildung einer konkav gekrümmten, nanostrukturierten Stempelfläche (7f) und
- Aushärtung des Stempelformmaterials (10).

3. Verfahren nach Anspruch 2, bei dem sich der Umfangsabschnitt über weniger als die Hälfte, insbesondere weniger als ein Drittel, vorzugsweise weniger als ein Viertel des Umfangs der Mantelfläche (5o) erstreckt.

## Claims

1. Use of a body of revolution (5) of an embossing roll (16) for production of a nanostructure die (1) with a concavely curved nanostructured die surface (7f) for seamless embossing in the step-and-repeat process of at least one peripheral ring (15, 15') of a jacket surface (13o), wherein the nanostructure die (1) has a die carrier (11) to which a die form (7) which encompasses the die surface (7f) is connected.

2. A method for producing a nanostructure die (1) for producing an embossing roll (16) for continuous embossing of nanostructures with the following steps, especially the following sequence:
- fixing of a curved or curvable die negative (9) of the nanostructure die (1) on a peripheral section of one jacket surface (5o) of a body of revolution (5),
- application of a moldable die form material (10) to the curved die negative (9),
- molding of the die form material (10) on a die carrier (11) for forming a concavely curved nanostructured die surface (7f),
- curing of the die form material (10).

3. The method as claimed in Claim 2, in which the peripheral section extends over less than half, especially less than one third, preferably less than one fourth, of the periphery of the jacket surface (5o),

## Revendications

1. Emploi d'un corps rotatif (5) d'un rouleau de marquage (16) pour fabriquer un tampon nanostructuré (1) qui comprend une surface de tampon (7f) concave, incurvée, nanostructurée pour le marquage sans soudure au cours d'un procédé stop-and-repeat d'au moins une bague périphérique (15, 15') d'une surface latérale (13o), sachant que le tampon nanostructuré (1) présente un support de tampon (11), auquel est relié un moule à tampon (7) comprenant la surface de tampon (7f).

2. Procédé de fabrication d'un tampon nanostructuré (1) pour fabriquer un rouleau de marquage (16) pour le marquage sans fin de nanostructures, comprenant les étapes suivantes, en particulier le déroulement suivant :
- fixation d'un négatif de tampon (9) incurvé ou pouvant être incurvé du tampon nanostructuré (1) sur un tronçon périphérique d'une surface latérale (5o) d'un corps rotatif (5),
- application d'un matériau de moule de tampon déformable (10) sur le négatif de tampon (9) incurvé,
- formage du matériau de moule de tampon (10) sur un support de tampon (11) pour former une surface de tampon (7f) concave, incurvée, nanostructurée et
- durcissement du matériau de moule de tampon (10).

3. Procédé selon la revendication 2, dans lequel le tronçon périphérique s'étend sur moins de la moitié, en particulier moins d'un tiers, de préférence moins d'un quart du pourtour de la surface latérale (5o).
